# FASCICULE DE BREVET EUROPEEN

(11) **EP 1 993 965 B1**
(45) Date de publication et mention de la délivrance du brevet: **16.05.2018**
(21) Numéro de dépôt: 07731699.0
(22) Date de dépôt: 06.03.2007
(51) Int. Cl.: C03C 17/36, B32B 17/10

(54) **SUBSTRAT MUNI D'UN EMPILEMENT A PROPRIETES THERMIQUES**
SUBSTRAT MIT STAPEL MIT THERMISCHEN EIGENSCHAFTEN
SUBSTRATE COMPRISING A STACK HAVING THERMAL PROPERTIES

(30) Priorité: 06.03.2006 FR 0650771
(43) Date de publication de la demande: 26.11.2008
(73) Titulaire: SAINT-GOBAIN GLASS FRANCE, 92400 Courbevoie (FR)
(72) Inventeur: REUTLER, Pascal, F-75019 Paris (FR); PETITJEAN, Eric, F-93260 Les Lilas (FR); MATTMANN, Eric, F-75013 Paris (FR); GILLET, Pierre-Alain, B-1410 Waterloo (BE)
(74) Mandataire: Saint-Gobain Recherche
(86) Numéro de dépôt international: PCT/FR2007/050882
(87) Numéro de publication internationale: WO 2007/101964

(56) Documents cités:
- EP-A- 0 877 005
- EP-A2- 0 718 250
- WO-A-01/81262
- WO-A1-2007/080428
- FR-A1- 2 856 627
- US-A1- 2002 034 641
- US-A1- 2003 049 464

## Description

L'invention concerne les substrats transparents, notamment en matériau rigide minéral comme le verre, lesdits substrats étant revêtus d'un empilement de couches minces comprenant une couche fonctionnelle de type métallique pouvant agir sur le rayonnement solaire et/ou le rayonnement infrarouge de grande longueur d'onde.

L'invention concerne plus particulièrement l'utilisation de tels substrats pour fabriquer des vitrages d'isolation thermique et/ou de protection solaire. Ces vitrages peuvent être destinés aussi bien à équiper les bâtiments que les véhicules, en vue notamment de diminuer l'effort de climatisation et/ou d'empêcher une surchauffe excessive (vitrages dits « de contrôle solaire ») et/ou diminuer la quantité d'énergie dissipée vers l'extérieur (vitrages dits « bas émissifs ») entraînés par l'importance toujours croissante des surfaces vitrées dans les bâtiments et les habitacles de véhicules.

Ces vitrages peuvent par ailleurs être intégrés dans des vitrages présentant des fonctionnalités particulières, comme par exemple des vitrages chauffants ou des vitrages électrochromes.

Un type d'empilement de couches connu pour conférer aux substrats de telles propriétés est constitué d'une couche métallique fonctionnelle à propriétés de réflexion dans l'infrarouge et/ou dans le rayonnement solaire, notamment une couche fonctionnelle métallique à base d'argent ou d'alliage métallique contenant de l'argent.

Cette couche fonctionnelle métallique est déposée sous une forme cristallisée sur une couche de mouillage également cristallisée favorisant l'orientation cristalline adéquate de la couche métallique déposée dessus.

Cette couche fonctionnelle se trouve disposée entre deux revêtements en matériau diélectrique du type oxyde ou nitrure métallique. L'empilement est généralement obtenu par une succession de dépôts effectués par une technique utilisant le vide comme la pulvérisation cathodique éventuellement assistée par champ magnétique. Peuvent aussi être prévus un, voire deux, revêtement(s) très fin(s) appelé(s) « revêtement de blocage », disposé(s) directement sous, sur ou de chaque côté de chaque couche métallique fonctionnelle à base d'argent, le revêtement sous-jacent en tant que revêtement d'accrochage, de nucléation et/ou de protection lors d'un éventuel traitement thermique postérieurement au dépôt, et le revêtement sus-jacent en tant que revêtement de protection ou « sacrificiel » afin d'éviter l'altération de l'argent si une couche qui le surmonte est déposée par pulvérisation cathodique en présence d'oxygène ou d'azote et/ou si l'empilement subit postérieurement au dépôt un traitement thermique.

Il est connu de la demande de brevet N° EP 718 250 un empilement de couches minces comprenant une couche fonctionnelle métallique en argent qui est déposée sur une couche de mouillage en oxyde de zinc qui est elle-même déposée sur une couche à base de nitrure de silicium qui est située sur une face d'un substrat.

Il est en outre connu de la demande de brevet N° FR 2 856 627 une couche de couverture qui est une couche de protection et qui peut être à base d'oxyde mixte de zinc et d'étain.

Il est connu de la demande de brevet européen N°EP 803 481, l'utilisation sous une couche de mouillage à base d'oxyde de zinc d'une couche amorphe à base d'oxyde mixte de zinc et d'étain directement au contact du substrat.

Il s'avère qu'une telle couche amorphe lorsqu'elle n'est pas déposée directement sur le substrat mais qu'elle est intercalée entre au moins une couche diélectrique sous-jacente et une couche de mouillage permet de modifier l'interface entre la couche diélectrique et la couche de mouillage située au-dessus et ainsi d'améliorer sensiblement la cristallisation de la couche de mouillage ainsi que la cristallisation de la couche métallique fonctionnelle. EP 0 877 005 décrit un tel empilement. Il a été découvert que d'une manière surprenante, l'intégration d'une telle couche amorphe dans le revêtement sous-jacent à la couche fonctionnelle et pourvu d'au moins une couche diélectrique à base de nitrure sous cette couche amorphe permet de parvenir à une amélioration souhaitée de la cristallisation des couches fonctionnelles et ainsi à une amélioration souhaitée de la résistivité de l'empilement complet.

Le but de l'invention est de parvenir à remédier aux inconvénients de l'art antérieur, en mettant au point un nouveau type d'empilement de couches du type de ceux décrits précédemment, empilement qui présente une résistivité améliorée, plus faible que dans un empilement similaire à épaisseur de couche fonctionnelle et revêtements équivalents, que l'empilement subisse ou non, un (ou des) traitement(s) thermique(s) à haute température du type bombage, trempe ou recuit et dans le cas où il subit un (ou plusieurs) tel(s) traitement(s), tout en préservant sa qualité optique et sa tenue mécanique.

L'invention a ainsi pour objet, dans son acception la plus large, un substrat, notamment substrat verrier transparent, muni d'un empilement de couches minces selon la revendication 1. Cet empilement comporte une couche fonctionnelle à propriétés de réflexion dans l'infrarouge et/ou dans le rayonnement solaire, notamment une couche fonctionnelle métallique à base d'argent ou d'alliage métallique contenant de l'argent, et deux revêtements, lesdits revêtements étant composés d'une pluralité de couches diélectriques, de manière à ce que la couche fonctionnelle soit disposée entre deux revêtements, la couche fonctionnelle étant déposée sur une couche de mouillage déposée elle-même directement sur un revêtement sous-jacent ; le revêtement sous-jacent comprend au moins une couche diélectrique à base de nitrure de silicium et/ou de nitrure d'aluminium et au moins une couche de lissage non cristallisée en un oxyde mixte, ladite couche de lissage étant en contact avec ladite couche de mouillage sus-jacente.

L'invention consiste ainsi à prévoir une couche de lissage non cristallisée sous la couche de mouillage qui elle est cristallisée pour permettre une croissance adéquate de la couche fonctionnelle située au-dessus de cette couche de mouillage, directement au contact de la couche de mouillage.

Il est apparu que dans le cas où le revêtement sous-jacent comprend au moins une couche diélectrique à base de nitrure de silicium et/ou de nitrure d'aluminium, choisir une couche de lissage comme indiqué en revendication 1, non cristallisée, en un oxyde mixte, permettait d'obtenir une bonne résistivité de l'empilement et des propriétés optiques adaptées aux attentes que le substrat subisse ou non un traitement thermique après dépôt.

L'invention s'applique ainsi aux substrats dits « trempables ou non » dans la mesure où il est possible sur une même façade de bâtiment par exemple de disposer à proximité les uns des autres des vitrages intégrant des substrats trempés et des substrats non trempés, sans qu'il ne soit possible de les distinguer les uns des autres par une simple observation visuelle de la couleur en réflexion et de la réflexion lumineuse.

Au sens de la présente invention lorsqu'il est précisé qu'un dépôt de couche ou de revêtement (comportant une ou plusieurs couches) est effectué directement sous ou directement sur un autre dépôt, c'est qu'il ne peut y avoir interposition d'aucune couche entre ces deux dépôts.

La couche de lissage est dite « non cristallisée » dans le sens où elle peut être complètement amorphe ou partiellement amorphe et ainsi partiellement cristallisée, mais qu'elle ne peut pas être complètement cristallisée, sur toute son épaisseur. Elle ne peut être de nature métallique car elle est à base d'oxyde mixte (un oxyde mixte est un oxyde d'au moins deux éléments).

L'aspect cristallographique de la couche de lissage est forcément différent de celui de la couche de mouillage puisque la couche de lissage est non cristallisée alors que la couche de mouillage est, pour l'essentiel, cristallisée ; elles ne peuvent donc être confondues de ce point de vue.

L'intérêt d'une telle couche de lissage est de permettre d'obtenir une interface avec la couche de mouillage directement sus-jacente qui est peu rugueuse. Cette faible rugosité est d'ailleurs observable au microscope électronique à transmission.

Par ailleurs, la couche de mouillage se texture mieux et présente en outre une orientation cristallographique préférentielle plus marquée.

Chaque couche de lissage est ainsi en un matériau différent, tant du point de vue cristallographique que stoechiométrique, de celui de la couche de mouillage sous laquelle elle est directement disposée.

La couche à base de nitrure du revêtement sous-jacent, qui comporte par ailleurs la couche de lissage, est au contact du substrat, directement ou indirectement par l'intermédiaire d'une couche de contact par exemple à base d'oxyde de titane (TiO₂).

L'indice de cette couche à base de nitrure est, de préférence, inférieur à 2,2.

La couche de lissage est une couche d'oxyde mixte à base de zinc et d'étain.

L'indice de la couche de lissage est, de préférence, inférieur à 2,2.

De préférence en outre, la couche de lissage, est une couche d'oxyde mixte non stoechiométrique en oxygène et plus particulièrement encore une couche d'oxyde mixte à base de zinc et d'étain sous-stoechiométrique dopée à l'antimoine (SnZnOₓ:Sb, x étant un nombre).

Par ailleurs, la couche de lissage présente une épaisseur géométrique comprise entre 0,2 et 10 nm.

Dans une variante préférée, au moins un revêtement de blocage est à base de Ni ou de Ti ou est à base d'un alliage à base de Ni, notamment est à base d'un alliage de NiCr.

De plus, la couche de mouillage sous-jacente à la couche fonctionnelle est à base d'oxyde de zinc ; cette couche de mouillage peut être en particulier à base d'oxyde de zinc dopé à l'aluminium.

L'épaisseur géométrique de la couche de mouillage est de préférence comprise entre 2 et 30 nm et de préférence encore comprise entre 3 et 20 nm.

Le vitrage selon l'invention incorpore au moins le substrat porteur de l'empilement selon l'invention, éventuellement associé à au moins un autre substrat. Chaque substrat peut être clair ou coloré. Un des substrats au moins notamment peut être en verre coloré dans la masse. Le choix du type de coloration va dépendre du niveau de transmission lumineuse et/ou de l'aspect colorimétrique recherchés pour le vitrage une fois sa fabrication achevée.

Ainsi pour des vitrages destinés à équiper des véhicules, certaines normes imposent que le pare-brise présente une transmission lumineuse T_{L} d'environ 75% et d'autres normes imposent une transmission lumineuse T_{L} d'environ 65% ; un tel niveau de transmission n'étant pas exigé pour les vitrages latéraux ou le toit-auto, par exemple. Les verres teintés que l'on peut retenir sont par exemple ceux qui, pour une épaisseur de 4 mm, présentent une T_{L} de 65 % à 95 %, une transmission énergétique T_{E} de 40 % à 80 %, une longueur d'onde dominante en transmission de 470 nm à 525 nm associée à une pureté de transmission de 0,4 % à 6 % selon l'Illuminant D₆₅, ce que l'on peut « traduire » dans le système de colorimétrie (L, a*, b*) par des valeurs de a* et b* en transmission respectivement comprises entre -9 et 0 et entre -8 et +2.

Pour des vitrages destinés à équiper des bâtiments, le vitrage présente, de préférence, une transmission lumineuse T_{L} d'au moins 75% voire plus pour des applications « bas-émissif », et une transmission lumineuse T_{L} d'au moins 40% voire plus pour des applications « contrôle solaire ».

Le vitrage selon l'invention peut présenter une structure feuilletée, associant notamment au moins deux substrats rigides du type verre par au moins une feuille de polymère thermoplastique, afin de présenter une structure de type verre/empilement de couches minces/feuille(s)/verre. Le polymère peut notamment être à base de polyvinylbutyral PVB, éthylène vinylacétate EVA, polyéthylène téréphtalate PET, polychlorure de vinyle PVC.

Le vitrage peut aussi présenter une structure de vitrage feuilleté dit asymétrique, associant un substrat rigide de type verre à au moins une feuille de polymère de type polyuréthane à propriétés d'absorbeur d'énergie, éventuellement associée à une autre couche de polymères à propriétés « auto-cicatrisantes ». Pour plus de détails sur ce type de vitrage, il est possible de se reporter notamment aux brevets EP-0 132 198, EP-0 131 523, EP-0 389 354.

Le vitrage peut alors présenter une structure de type verre/empilement de couches minces/feuille(s) de polymère.

Les vitrages selon l'invention sont aptes à subir un traitement thermique sans dommage pour l'empilement de couches minces. Ils sont donc éventuellement bombés et/ou trempés.

Le vitrage peut être bombé et/ou trempé en étant constitué d'un seul substrat, celui muni de l'empilement. Il s'agit alors d'un vitrage dit « monolithique ». Dans le cas où ils sont bombés, notamment en vue de constituer des vitrages pour véhicules, l'empilement de couches minces se trouve de préférence sur une face au moins partiellement non plane.

Le vitrage peut aussi être un vitrage multiple, notamment un double-vitrage, au moins le substrat porteur de l'empilement pouvant être bombé et/ou trempé. Il est préférable dans une configuration de vitrage multiple que l'empilement soit disposé de manière à être tourné du côté de la lame de gaz intercalaire. Dans une structure feuilletée, le substrat porteur de l'empilement est de préférence en contact avec la feuille de polymère.

Lorsque le vitrage est monolithique ou multiple du type double-vitrage ou vitrage feuilleté, au moins le substrat porteur de l'empilement peut être en verre bombé ou trempé, ce substrat pouvant être bombé ou trempé avant ou après le dépôt de l'empilement.

L'invention concerne également le procédé de fabrication des substrats selon l'invention, qui consiste à déposer l'empilement de couches minces sur son substrat par une technique sous vide du type pulvérisation cathodique éventuellement assistée par champ magnétique, puis à effectuer sur le substrat revêtu un traitement thermique de bombage/trempe ou recuit sans dégradation de sa qualité optique et/ou mécanique.

Il n'est toutefois pas exclu que la première ou les premières couches de l'empilement puisse(nt) être déposée(s) par une autre technique, par exemple par une technique de décomposition thermique de type pyrolyse.

Les détails et caractéristiques avantageuses de l'invention ressortent des exemples non limitatifs suivants, illustrés à l'aide des figures ci-jointes :
- La figure 1 illustre l'évolution, avant traitement thermique, de la résistance par carré d'un empilement monocouche fonctionnelle pourvu d'un revêtement monocouche de sur-blocage, sans et avec une couche de lissage, en fonction de l'épaisseur de la couche diélectrique placée dessous ;
- La figure 2 illustre l'évolution, après traitement thermique, de la résistance par carré du même empilement monocouche fonctionnelle qu'en figure 1, sans et avec une couche de lissage, en fonction de l'épaisseur de la couche diélectrique placée dessous ;
- La figure 3 illustre l'évolution, avant traitement thermique, de la résistance par carré d'un empilement monocouche fonctionnelle pourvu d'un revêtement monocouche de sur-blocage en fonction de l'épaisseur de la couche de lissage ;
- La figure 4 illustre l'évolution, après traitement thermique, de la résistance par carré du même empilement monocouche fonctionnelle qu'en figure 3 en fonction de l'épaisseur de la couche de lissage ;
- La figure 5 illustre un empilement monocouche fonctionnelle selon l'invention, la couche fonctionnelle étant pourvue d'un revêtement de sur-blocage mais pas d'un revêtement de sous-blocage ;
- La figure 6 illustre un empilement monocouche fonctionnelle selon l'invention, la couche fonctionnelle étant pourvue d'un revêtement de sous-blocage mais pas d'un revêtement de sur-blocage ; et
- La figure 7 illustre un empilement monocouche fonctionnelle selon l'invention, la couche fonctionnelle étant pourvue d'un revêtement de sous-blocage et d'un revêtement de sur-blocage.

Dans les figures illustrant des empilements de couches, les proportions entre les épaisseurs des différents matériaux ne sont pas rigoureusement respectées afin de faciliter leur lecture.

Par ailleurs, dans tous les exemples ci-après l'empilement de couches minces est déposé sur un substrat 10 en verre sodo-calcique d'une épaisseur de 2 mm.

Dans tous les cas où un traitement thermique a été appliqué au substrat, il s'agissait d'un recuit pendant environ 5 minutes à une température d'environ 660 °C suivi d'un refroidissement à l'air ambiant (environ 20 °C).

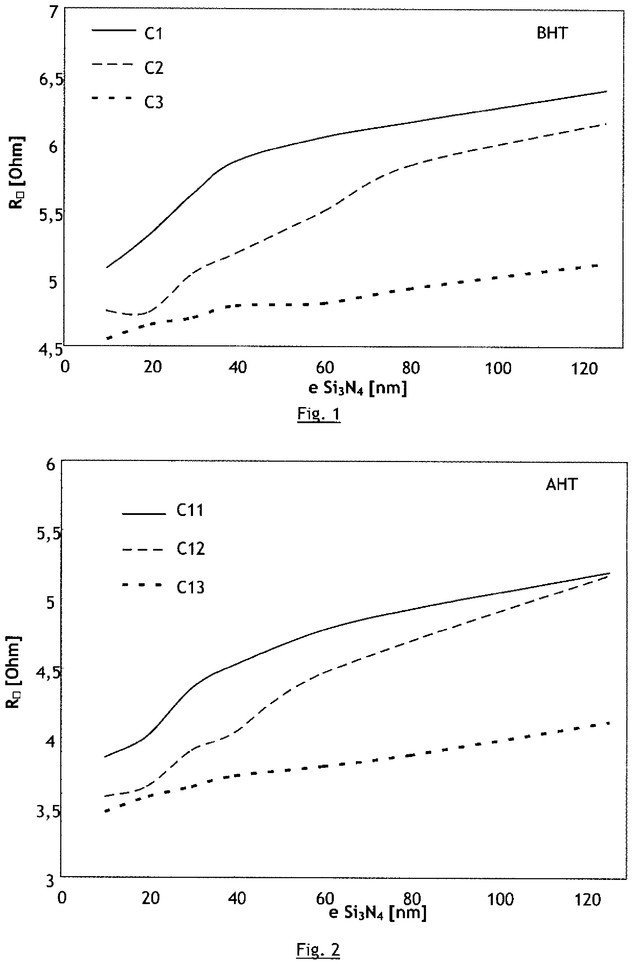

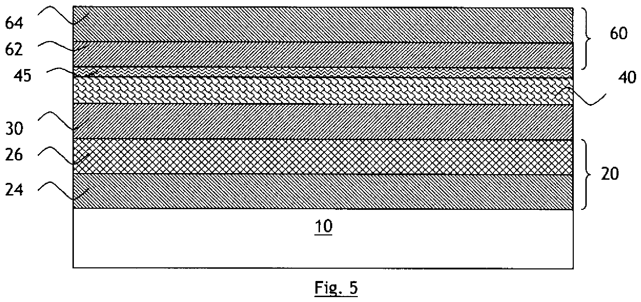

Les figures 1 à 4 ont pour but d'illustrer l'importance de la présence d'une couche de lissage dans un empilement du type de celui illustré sur la figure 5, qui illustre un empilement selon l'invention.

Un exemple, numéroté 1 d'empilement monocouche fonctionnelle selon l'invention est du type :
Substrat / Si₃N₄ / SnZnOₓ:Sb / ZnO / Ag /Ti / ZnO / Si₃N₄ Variable / Variable / 8nm / 10nm / 2nm / 8nm / 20 nm

Sur les figures 1 et 2, les courbes C1 et C11 illustrent la variation de la résistance par carré (en ohms) de l'empilement en fonction de l'épaisseur de la couche de diélectrique à base de nitrure de silicium (e Si₃N₄) en contact avec le substrat, respectivement avant (BHT) et après (AHT) traitement thermique, lorsque l'empilement n'est pas pourvu d'une couche de lissage.

Les courbes C2 et C12 illustrent la variation de la résistance par carré (en ohms) de l'empilement en fonction de l'épaisseur de la couche de diélectrique à base de nitrure de silicium (e Si₃N₄) en contact avec le substrat, respectivement avant et après traitement thermique, lorsque l'empilement est pourvu d'une couche de lissage en SnZnOₓ:Sb d'une épaisseur de 6 nm (x désigne un nombre non nul).

Les courbes C3 et C13 illustrent la variation de la résistance par carré (en ohms) de l'empilement en fonction de l'épaisseur de la couche de diélectrique à base de nitrure de silicium (e Si₃N₄) en contact avec le substrat, respectivement avant et après traitement thermique, lorsque l'empilement est pourvu d'une couche de lissage à base de SnZnOₓ:Sb d'une épaisseur de 20 nm.

Comme visible sur ces figures 1 et 2, pour une même épaisseur de diélectrique en contact avec le substrat (par exemple 20 nm), la résistance par carré de l'empilement est toujours plus faible - donc meilleure - pour les courbes C2, C3, C12 et C13 lorsque l'empilement comporte une couche de lissage à base de SnZnOₓ:Sb entre la couche de diélectrique à base de nitrure de silicium en contact avec le substrat et la couche de mouillage à base d'oxyde de zinc ZnO sous-jacente à la couche fonctionnelle à base d'argent Ag et la résistance par carré de l'empilement est toujours plus faible pour une épaisseur de couche de lissage de 20 nm (courbes C3 et C13).

Il a été vérifié que la couche de lissage en oxyde mixte est amorphe sur toute son épaisseur, alors que la couche de mouillage et la couche fonctionnelle métallique sont toutes les deux cristallisées, sur toute leur épaisseur.

En conséquence, la présence de la couche de lissage améliore d'une manière importante la résistance par carré de l'empilement à épaisseur de diélectrique sous-jacent comparable et cette amélioration est d'autant plus forte que l'épaisseur de la couche de lissage est importante.

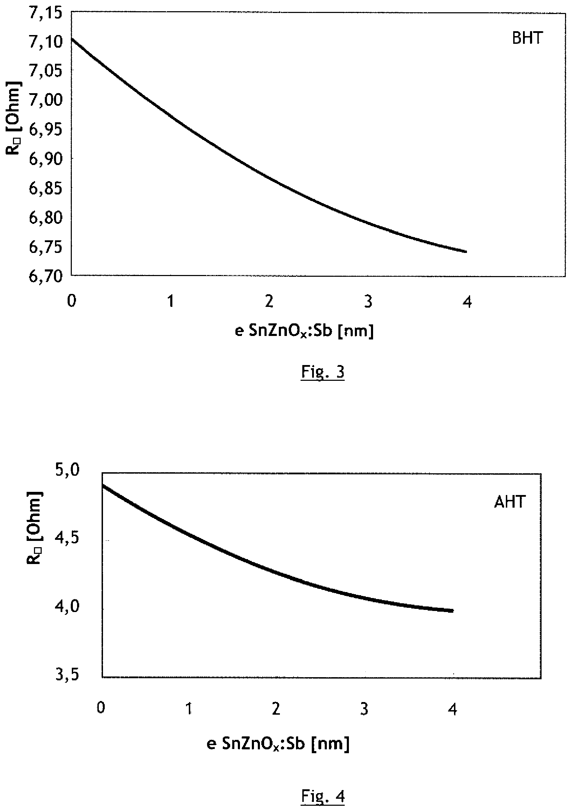

Sur les figures 3 et 4, les courbes illustrent la variation de la résistance par carré (en ohms) de l'empilement en fonction de l'épaisseur de la couche de lissage à base d'oxyde de zinc et d'étain dopé à l'antimoine (e SnZnOₓ:Sb), respectivement avant (BHT) et après (AHT) traitement thermique, lorsque l'empilement est pourvu d'une couche à base de nitrure de silicium Si₃N₄ de 20 nm entre le substrat et la couche à base de SnZnOₓ:Sb.

Il a aussi été vérifié que la couche de lissage en oxyde mixte est amorphe sur toute son épaisseur, alors que la couche de mouillage et la couche fonctionnelle métallique sont toutes les deux cristallisées, sur toute leur épaisseur.

Comme visible sur ces figures 3 et 4 également, la présence de la couche de lissage améliore d'une manière importante la résistance par carré de l'empilement pour une couche de lissage comprise entre > 0 et 4 nm d'épaisseur et cette amélioration est d'autant plus forte que l'épaisseur de la couche de lissage est importante.

Des constatations similaires peuvent être faites avec un empilement monocouche fonctionnelle pourvu d'un revêtement de sous-blocage et sans revêtement de sur-blocage ou pourvu d'un revêtement de sous-blocage et d'un revêtement de sur-blocage.

Une autre série d'essai a été réalisée.

Trois exemples, numérotés 2, 3 et 4, ont été réalisés sur la base de la structure d'empilement monocouche fonctionnelle illustrée figure 5 dans laquelle la couche fonctionnelle 40 est pourvue d'un revêtement de sur-blocage 45.

Le tableau 1 ci-après illustre les épaisseurs en nanomètres de chacune des couches :

**Tableau 1**

| Couche | Matériau | Ex. 2 | Ex. 3 | Ex. 4 |
|---|---|---|---|---|
| 64 | Si₃N₄ | 40 | 40 | 40 |
| 62 | ZnO | 10 | 10 | 10 |
| 45 | Ti | 2 | 2 | 2 |
| 40 | Ag | 10 | 10 | 10 |
| 30 | ZnO | 10 | 10 | 10 |
| 26 | SnZnOₓ:Sb | - | - | 10 |
| 24 | Si₃N₄ | 30 | 30 | 20 |

Les caractéristiques de résistivité, optiques et énergétiques de ces exemples sont reportées dans le tableau 2 ci-après :

**Tableau 2**

| Ex. | R_{□} (ohms) | R_{L} (%) | T_{L}(%) | a*(D65) | b*(D65) | E (%) |
|---|---|---|---|---|---|---|
| 2 BHT | 5,7 | 4,4 | 86,5 | 2,3 | -5,2 | 6 |
| 2 AHT | - | - | - | - | - | - |
| 3 BHT | 6,9 | 4,4 | 85,6 | 2,9 | -7,8 | 8 |
| 3 AHT | 5,2 | 4,5 | 87,1 | 6,5 | -6 | 6 |
| 4 BHT | 5,8 | 5,7 | 87 | 1,3 | -3,5 | 6 |
| 4 AHT | 4,3 | 4,3 | 88,7 | 3,3 | -5,7 | 5 |

Ainsi, la résistivité de l'empilement tant avant qu'après traitement thermique de l'exemple 4 selon l'invention est toujours inférieure respectivement aux contre-exemples 3 et 2.

De plus, la réflexion lumineuse R_{L}, la transmission lumineuse T_{L} mesurées selon l'illuminant D65 et les couleurs en réflexion a* et b* dans le système LAB mesurées selon l'illuminant D65 côté couches ne varient pas de manière vraiment significative entre l'exemples selon l'invention et les contre-exemples 3 et 2.

En comparant les caractéristiques optiques et énergétiques avant traitement thermique avec ces mêmes caractéristiques après traitement thermique, aucune dégradation majeure n'a été constatée.

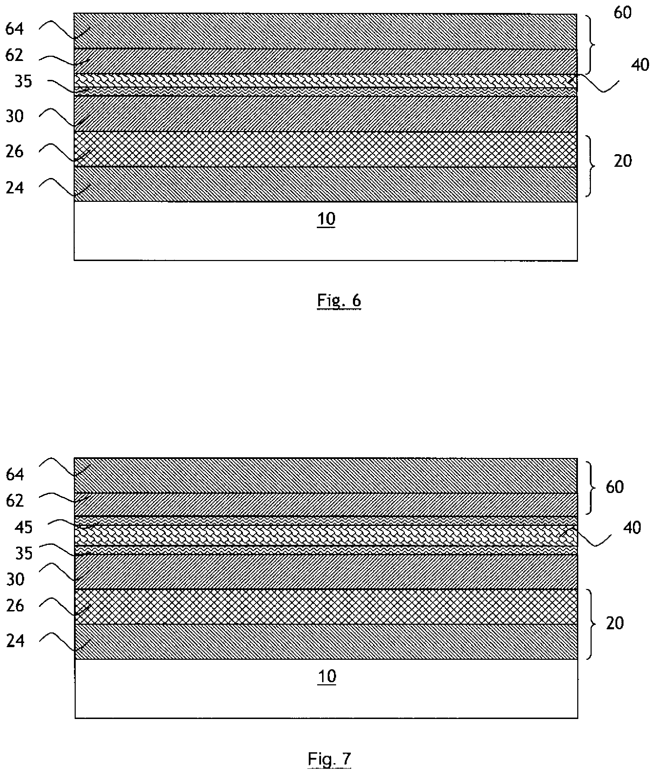

D'autres essais ont été réalisés sur la base de la structure d'empilement monocouche fonctionnelle illustrée figure 6 dans laquelle la couche fonctionnelle 40 est pourvue d'un revêtement de sous-blocage 35 mais pas d'un revêtement de sur-blocage 45.

D'autres essais ont été réalisés sur la base de la structure d'empilement monocouche fonctionnelle illustrée figure 7 dans laquelle la couche fonctionnelle 40 est pourvue d'un revêtement de sous-blocage 35 et d'un revêtement de sur-blocage 45.

Tous ces essais ont permis d'arriver à des constatations similaires.

Des essais ont en outre été conduis pour permettre de mesurer la rugosité des couches.

Le tableau 3 ci-après illustre les rugosités mesurées par réflectométrie X et exprimées en nm (la rugosité du substrat étant d'environ 0,4) :

**Tableau 3**

| Couche(s) | Epaisseur (nm) des couches | Rugosité σ (nm) |
|---|---|---|
| Si₃N₄ | 28,5 | 1,1 |
| Verre | Substrat | |
| SnInOₓ | 29,5 | 0,8 |
| Verre | Substrat | |
| SnZnOₓ:Sb | 32,0 | 0,7 |
| Verre | Substrat | |
| SnZnOₓ:Sb | 11,2 | 0,8 |
| Si₃N₄ | 19,7 | 0,5 |
| Verre | Substrat | |
| SnInOₓ | 10,4 | 0,8 |
| Si3N4 | 19,3 | 0,5 |
| Verre | Substrat | |

Comme visible dans ce tableau, la rugosité de la couche à base de nitrure de silicium Si₃N₄ déposée seule sur le verre est élevée, mais la rugosité finale d'un empilement comprenant une couche à base de oxyde d'étain et d'indium SnInOₓ (ITO) ou une couche à base d'oxyde mixte de zinc et d'étain SnZnOₓ:Sb déposée sur la couche à base de nitrure de silicium est moins élevée. La couche de mouillage à base d'oxyde mixte permet ainsi d'améliorer la rugosité de l'interface au contact de la couche de mouillage, en diminuant cette rugosité.

La présente invention est décrite dans ce qui précède à titre d'exemple. Il est entendu que l'homme du métier est à même de réaliser différentes variantes de l'invention sans pour autant sortir du cadre du brevet tel que défini par les revendications.

## Revendications

1. Substrat (10), notamment substrat verrier transparent, muni d'un empilement de couches minces comportant une couche fonctionnelle (40) à propriétés de réflexion dans l'infrarouge et/ou dans le rayonnement solaire, notamment métallique à base d'argent ou d'alliage métallique contenant de l'argent, et deux revêtements (20, 60), lesdits revêtements étant composés d'une pluralité de couches diélectriques (24, 26 ; 64), de manière à ce que la couche fonctionnelle (40) soit disposée entre les deux revêtements (20, 60), la couche fonctionnelle (40) étant déposées, directement au contact, sur une couche de mouillage (30) à base d'oxyde de zinc déposée elle-même directement sur un revêtement sous-jacent (20), **caractérisé en ce que** le revêtement sous-jacent (20) comprend au moins une couche diélectrique (24) à base de nitrure de silicium et/ou de nitrure d'aluminium et au moins une couche de lissage (26) non cristallisée en un oxyde mixte, ladite couche de lissage (26) étant en contact avec ladite couche de mouillage (30) sus-jacente et la couche de lissage (26) étant une couche d'oxyde mixte à base de zinc et d'étain éventuellement dopée, la couche de lissage (26) présentant une épaisseur géométrique comprise entre 0,2 et 10 nm.

2. Substrat (10) selon l'une quelconque des revendications précédentes, ***caractérisé en ce que*** la couche de lissage (26) est une couche d'oxyde non stoechiométrique en oxygène.

3. Substrat (10) selon l'une quelconque des revendications précédentes, ***caractérisé en ce que*** la couche fonctionnelle (40) est disposée directement sous au moins un revêtement de blocage (45) sus-jacent.

4. Substrat (10) selon la revendication précédente, ***caractérisé en ce qu'***au moins un revêtement de blocage (45) est à base de Ni ou de Ti ou est à base d'un alliage à base de Ni, notamment est à base d'un alliage de NiCr.

5. Substrat (10) selon l'une quelconque des revendications précédentes, ***caractérisé en ce que*** ladite couche de mouillage (30) présente une épaisseur géométrique comprise entre 2 et 30 nm, et de préférence comprise entre 3 et 20 nm.

6. Vitrage incorporant au moins un substrat (10) selon l'une quelconque des revendications précédentes, éventuellement associé à au moins un autre substrat.

7. Vitrage selon la revendication précédente monté en monolithique ou en vitrage multiple du type double-vitrage ou vitrage feuilleté, ***caractérisé en ce qu'au*** moins le substrat porteur de l'empilement est bombé ou trempé.

8. Procédé de fabrication du substrat (10) selon l'une quelconque des revendications 1 à 5, ***caractérisé en ce qu'on*** dépose l'empilement de couches minces sur le substrat par une technique sous vide du type pulvérisation cathodique éventuellement assistée par champ magnétique, puis ***en ce qu'on*** effectue un traitement thermique du type bombage, trempe ou recuit sur ledit substrat, sans dégradation de sa qualité optique et/ou mécanique.

## Patentansprüche

1. Substrat (10), insbesondere transparentes Glassubstrat, ausgestattet mit einer Stapelung von Dünnschichten, umfassend eine funktionelle Schicht (40) mit Reflektionseigenschaften im Infrarot und/oder im Sonnenstrahlenbereich, insbesondere metallisch, basierend auf Silber oder einer Metalllegierung, enthaltend Silber, und zwei Beschichtungen (20, 60), wobei die Beschichtungen aus einer Vielzahl von dielektrischen Schichten (24, 26; 64) zusammengesetzt sind, so dass die funktionelle Schicht (40) zwischen den zwei Beschichtungen (20, 60) angeordnet ist, wobei die funktionelle Schicht (40) direkt in Kontakt auf einer Benetzungsschicht (30) basierend auf Zinkoxid abgelagert ist, die selbst auf einer darunter liegenden Beschichtung (20) abgelagert ist, **dadurch gekennzeichnet, dass** die darunter liegende Beschichtung (20) mindestens eine dielektrische Schicht (24) basierend auf Siliciumnitrid und/oder Aluminiumnitrid und mindestens eine nicht kristallisierte Glättungsschicht (26) aus einem Mischoxid umfasst, wobei die Glättungsschicht (26) in Kontakt mit der darunter liegenden Benetzungsschicht (30) ist, und die Glättungsschicht (26) eine Mischoxidschicht basierend auf Zink und Zinn, eventuell dotiert, ist, wobei die Glättungsschicht (26) eine geometrische Stärke zwischen 0,2 und 10 nm aufweist.

2. Substrat (10) nach einem der vorhergehenden Ansprüche, **dadurch gekennzeichnet, dass** die Glättungsschicht (26) eine an Sauerstoff nicht stöchiometrische Oxidschicht ist.

3. Substrat (10) nach einem der vorhergehenden Ansprüche, **dadurch gekennzeichnet, dass** die funktionelle Schicht (40) direkt unter mindestens einer darünber liegenden Blockierungsbeschichtung (45) abgelagert ist.

4. Substrat (10) nach vorhergehendem Anspruch, **dadurch gekennzeichnet, dass** mindestens eine Blockierungsbeschichtung (45) auf Ni oder Ti basiert oder auf einer Legierung auf Ni-Basis, insbesondere auf einer NiCr-Legierung, basiert.

5. Substrat (10) nach einem der vorhergehenden Ansprüche, **dadurch gekennzeichnet, dass** die Benetzungsschicht (30) eine geometrische Stärke zwischen 2 und 30 nm und bevorzugt zwischen 3 und 20 nm aufweist.

6. Verglasung, enthaltend mindestens ein Substrat (10) nach einem der vorhergehenden Ansprüche, eventuell in Verbindung mit mindestens einem anderen Substrat.

7. Verglasung nach vorhergehendem Anspruch, die monolithisch oder als Mehrfachverglasung vom Typ Doppelverglasung oder Verbundverglasung aufgebaut ist, **dadurch gekennzeichnet, dass** mindestens das Trägersubstrat der Stapelung gewölbt oder gehärtet ist.

8. Verfahren zur Herstellung des Substrats (10) nach einem der Ansprüche 1 bis 5, **dadurch gekennzeichnet, dass** die Stapelung aus Dünnschichten auf dem Substrat anhand einer Vakuumtechnik vom Typ Sputtern, eventuell unterstützt durch Magnetfeld, ablagert wird, dann **dadurch, dass** eine Wärmebehandlung vom Typ Wölben, Härten oder Glühen auf dem Substrat ohne Beschädigung seiner optischen und/oder mechanischen Qualität ausgeführt wird

## Claims

1. A substrate (10), especially a transparent glass substrate, provided with a thin-film multilayer comprising a functional layer (40) having reflection properties in the infrared and/or in solar radiation, especially a metallic functional layer based on silver or on a metal alloy containing silver, and two coatings (20, 60), said coatings being composed of a plurality of dielectric layers (24, 26; 64), so that the functional layer (40) is placed between the two coatings (20, 60), the functional layer (40) being deposited, directly in contact, onto a wetting layer (30) based on zinc oxide itself deposited directly onto a subjacent coating (20), **characterized in that** the subjacent coating (20) comprises at least one dielectric layer (24) based on silicon nitride and/or aluminum nitride, and at least one noncrystalline smoothing layer (26) made from a mixed oxide, said smoothing layer (26) being in contact with said superjacent wetting layer (30) and the smoothing layer (26) being a layer of a mixed oxide based on zinc and tin, possibly doped, the smoothing layer (26) having a geometric thickness between 0.2 and 10 nm.

2. The substrate (10) as claimed in any one of the preceding claims, **characterized in that** the smoothing layer (26) is an oxide layer having a nonstoichiometric amount of oxygen.

3. The substrate (10) as claimed in any one of the preceding claims, **characterized in that** the functional layer (40) is placed directly under at least one superjacent blocking coating (45).

4. The substrate (10) as claimed in the preceding claim, **characterized in that** at least one blocking coating (45) is based on Ni or on Ti or is based on an Ni-based alloy, and especially is based on an NiCr alloy.

5. The substrate (10) as claimed in any one of the preceding claims, **characterized in that** the wetting layer (30) has a geometric thickness between 2 and 30 nm, and preferably between 3 and 20 nm.

6. A glazing unit incorporating at least one substrate (10) as claimed in any one of the preceding claims, optionally combined with at least one other substrate.

7. The glazing unit as claimed in the preceding claim, mounted in monolithic form or as multiple glazing of the double-glazing or laminated glazing type, **characterized in that** at least the substrate carrying the multilayer is curved or toughened.

8. A process for manufacturing the substrate (10) as claimed in any one of claims 1 to 5, **characterized in that** the thin-film multilayer is deposited on the substrate by a vacuum technique of the sputtering, optionally magnetron sputtering, type and then **in that** a heat treatment of the bending, toughening or annealing type is carried out on said substrate without degrading its optical and/or mechanical quality.
